# EUROPEAN PATENT APPLICATION

(11) **EP 3 626 801 A1**
(43) Date of publication of application: **25.03.2020**
(21) Application number: 18195866.1
(22) Date of filing: 21.09.2018
(51) Int. Cl.: C09K 11/06, H01B 3/18, H01L 51/50, C09B 5/62

(54) **NOVEL FLUORESCENT PYRENE DERIVATIVES, METHODS FOR PREPARING THE SAME, AND USES THEREOF**

(71) Applicant: Max-Planck-Gesellschaft zur Förderung der Wissenschaften e.V., 80539 München (DE)
(72) Inventor: Müllen, Klaus, 50939 Köln (DE); Wang, Xiao-Ye, 55118 Mainz (DE); Yao, Xuelin, 55131 Mainz (DE)
(74) Representative: v. Bezold & Partner Patentanwälte - PartG mbB

(57) **Abstract**

The present invention relates to boron-doped perylene or terrylene derivatives having one of the following general formulae 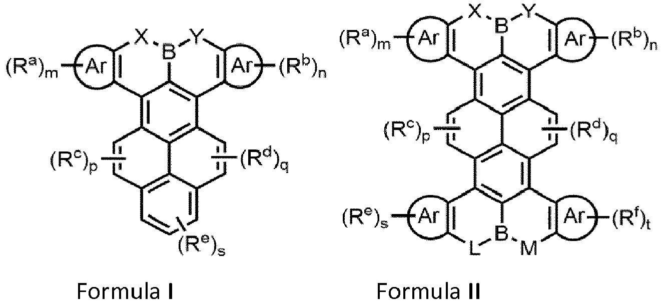 wherein X, Y, L and M independently are O, S, NH or NRx with Rx being any alkyl or (hetero)aryl group which may have substituent(s);
R^{a}, R^{b}, R^{e}, and R^{f} independently are selected from the group comprising unsubstituted or substituted (hetero)aryl, unsubstituted alkyne, alkene, alkyl, or alkoxy residues, and alkyne, alkene, alkyl, or alkoxy residues which are substituted or interrupted by other groups, as well as halogen, cyano, or nitro groups;
R^{c} and R^{d} independently are unsubstituted or substituted (hetero)aryl or alkyl groups, or halogen;
each Ar independently is an unsubstituted or substituted monocyclic or polycyclic (hetero)arene system, preferably benzene;
More specifically, X, Y, M and L represent O and Ar at each occurrence is benzene.

The invention also relates to methods for preparing these fluorescent compounds and to their use in the fields of electronics and optoelectronics, in particular as OLEDs, organic integrated circuits (O-ICs), fluorescent sensors, organic field effect transistors (OFETs), organic thin film transistors (OTFTs), organic solar cells (O-SCs), thermoelectric devices, electrochromic devices, or organic laser diodes.

## Description

### Background of the invention

Polycyclic aromatic compounds have attracted tremendous interest from both synthetic chemists and materials scientists during the past decades. They are often intriguing chromophores which form the basis of industrial dyes and colorants due to the extended π-conjugation, and serve as semiconductors in electronic and optoelectronic devices, such as in organic field-effect transistors (OFETs), organic light-emitting diodes (OLEDs), and organic photovoltaic cells. There has been a continuous demand for versatile organic materials, for example, stable blue emitters for OLEDs, high-mobility semiconductors for OFETs, light absorbers for solar energy conversion, and radical-bearing compounds for spintronics. One of the most appealing features of such organic π-conjugated molecules is that their optical, electronic, and magnetic properties can be effectively modulated by modifying the π-structure.

Pyrene, a classical polycyclic aromatic hydrocarbon and promising chromophore, has been frequently employed as a building block to develop novel π-extended systems. It can be readily functionalized at the 1-, 3-, 6-, and 8-positions by electrophilic substitution. The 4-, 5-, 9- and 10-positions (K-region) are also available for modifications through oxidation and further functionalizations. In contrast, the 2- and 7-positions are less reactive, which can be explained by looking at the frontier molecular orbitals of pyrene: In its highest occupied molecular orbital (HOMO) and lowest unoccupied molecular orbital (LUMO), there is a nodal plane passing through the 2- and 7-positions; reactions at these positions are thus very difficult. Remarkably, Marder *et al*. have developed an Ir-catalyzed borylation at the 2- and 7-positions of pyrene (Chem. Commun., 2005, 2172-2174), providing a new entry to 2- and 2,7-substituted pyrene derivatives (Crawford et al., J. Am. Chem. Soc., 2011, 133, 13349-13362; Crawford et al., Chem. Eur. J., 2012, 18, 5022-5035). The π-annulation at the non-K-region (1-, 2-, 3-, and 6-, 7-, 8-positions) of pyrene has thus been achieved recently through substitution at the 2- and 7-positions followed by further cyclizations (Yang et al., Angew. Chem. Int. Ed., 2016, 55, 10427-10430; Zou et al., J. Am. Chem. Soc., 2016, 138, 12783-12786).

Nevertheless, there is still an ongoing demand for novel pyrene derivatives, in particular for 2- or 2,7-substituted and non-K-region π-extended pyrene derivatives, with favorable characteristics such as strong fluorescence with high quantum yields, efficient charge transport properties suitable for organic field-effect transistors, and a main object of the present invention is to provide such favorable pyrene derivatives.

Said object is achieved according to the present invention by providing the compounds according to claims 1-10, the methods of synthesis according to claims 11-13, and the uses and devices according to claims 14-17.

### Description of the invention

The novel pyrene derivatives of the present invention generally are boron-doped perylene or terrylene derivatives having one of the following general formulae 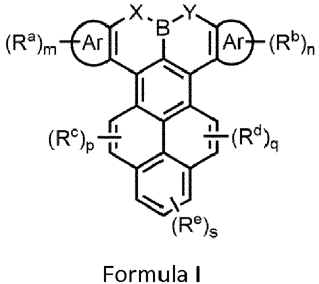
wherein X and Y independently are O, S, NH or NRx with Rx being any alkyl or (hetero)aryl group which may have substituent(s);
R^{a}, R^{b}, and R^{e} independently are selected from the group comprising unsubstituted or substituted (hetero)aryl, unsubstituted alkyne, alkene, alkyl, or alkoxy residues, and alkyne, alkene, alkyl, or alkoxy residues which are substituted or interrupted by other groups, as well as halogen, cyano, or nitro groups;
R^{c} and R^{d} independently are unsubstituted or substituted (hetero)aryl or alkyl groups, or halogen;
each Ar independently is an unsubstituted or substituted monocyclic or polycyclic (hetero)arene system;
m is an integer from 0 to 4; when m > 1, each R^{a} can be the same or different;
n is an integer from 0 to 4; when n > 1, each R^{b} can be the same or different;
p is an integer from 0 to 2; when p > 1, each R^{c} can be the same or different;
q is an integer from 0 to 2; when q > 1, each R^{d} can be the same or different;
s is an integer from 0 to 3; when e > 1, each R^{e} can be the same or different;
or 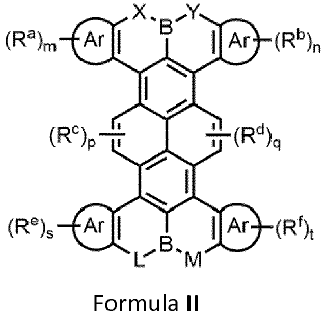
wherein X and Y independently are O, S, NH or NRx with Rx being any alkyl or (hetero)aryl group which may have substituent(s);
R^{a}, R^{b}, R^{e}, and R^{f} independently are selected from the group comprising unsubstituted or substituted (hetero)aryl, unsubstituted alkyne, alkene, alkyl, or alkoxy residues, and alkyne, alkene, alkyl, or alkoxy residues which are substituted or interrupted by other groups, as well as halogen, cyano, or nitro groups;
R^{c} and R^{d} independently are unsubstituted or substituted (hetero)aryl or alkyl groups, or halogen;
each Ar independently is an unsubstituted or substituted monocyclic or polycyclic (hetero)arene system;
m is an integer from 0 to 4; when m > 1, each R^{a} can be the same or different;
n is an integer from 0 to 4; when n > 1, each R^{b} can be the same or different;
p is an integer from 0 to 2; when p > 1, each R^{c} can be the same or different;
q is an integer from 0 to 2; when m > 1, each R^{d} can be the same or different;
s is an integer from 0 to 4; when s > 1, each R^{e} can be the same or different.
t is an integer from 0 to 4; when t > 1, each R^{f} can be the same or different;

More specifically, the substituent Rx may be selected from the group comprising optionally substituted (hetero)aryl, unsubstituted or substituted alkyl, e.g. straight or branched alkyl including lower alkyl, typically C₁-C₃₀ alkyl, in particular C₁-C₁₂ alkyl. If Rx represents a (hetero)aryl group, it is defined as indicated below with respect to the general definition of the terms "Ar" "aryl" and "heteroaryl", respectively.

More specifically, the substituents R^{a}-R^{e} in Formula I and R^{a}-R^{f} in formula II may be selected from the group comprising optionally substituted (hetero)aryl, unsubstituted or substituted alkyl, e.g. straight or branched alkyl including lower alkyl, typically C₁-C₃₀ alkyl, in particular C₁-C₁₂ alkyl, a halogen such as F, CI, Br, I. A substituted alkyl group may in particular comprise functional groups as indicated below with respect to the meaning of the general term "substituted alkyl". If one of R^{a}-R^{e} in Formula I or R^{a}-R^{f} in Formula II represents a (hetero)aryl group, it is defined as indicated below with respect to the general definition of the terms "Ar" "aryl" and "heteroaryl", respectively.

In some more specific embodiments Ar is selected from the group comprising 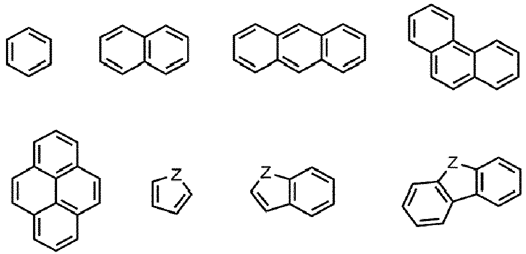
wherein Z is C or a heteroatom, in particular selected from the group comprising
O, S, N and P;
each Ar is independently fused on the boron-doped perylene or terrylene core sharing one carbon-carbon bond at any peripheral positions;
the substituents R^{a}, R^{b} in Formula I and R^{a}, R^{b}, R^{e}, R^{f} in formula II are independently attached on the Ar group at any possible positions.

The Ar substituents may be attached to the core structure at different linking positions, e.g. as shown in the following structural formulae

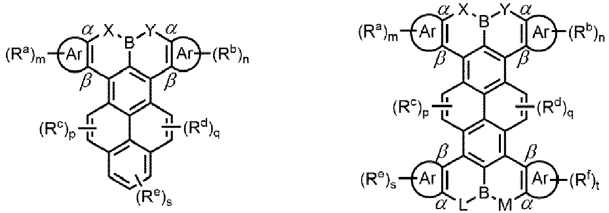

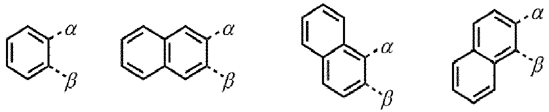

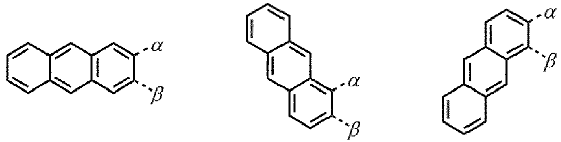

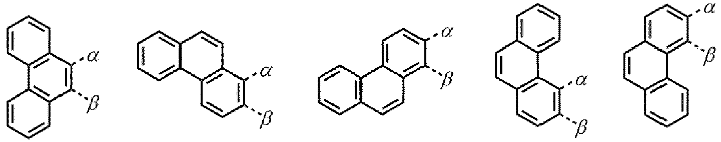

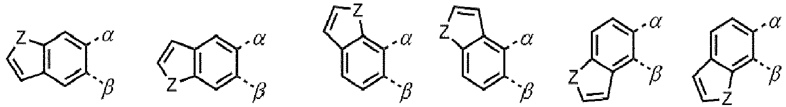

In a preferred embodiment, the boron-doped perylene or terrylene derivatives of the invention have one of the following general formulae 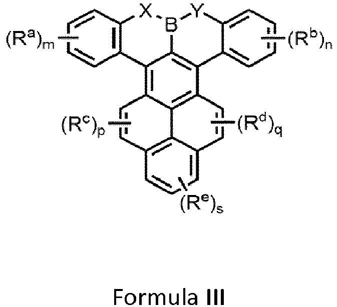 wherein X, Y, R^{a}-R^{e} and m, n, p, q and s are defined as in Formula I, or 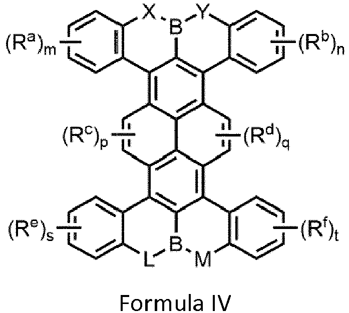 wherein X, Y, L, M, R^{a}-R^{f} and m, n, p, q, s and t are defined as in Formula II.

In another specific embodiment, the boron-doped perylene or terrylene derivatives of the invention have one of the following general formulae 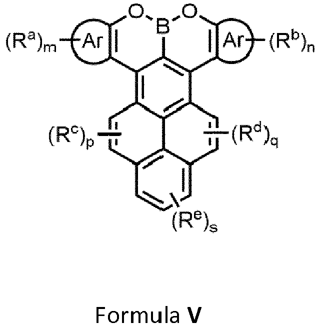 wherein Ar, R^{a}-R^{e} and m, n, p, q, s are defined as above, or 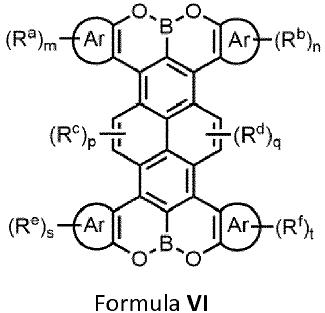 wherein Ar, R^{a}-R^{f} and m, n, p, q, s and t are defined as above.

In more specific embodiments of the boron-doped perylene or terrylene derivatives having the above Formulae I or **III,** the substituents X and Y are O or S, preferably O, and/or R^{a}-R^{e} independently are absent, i.e. one or more of m, n, p, q and s = 0, or alkyl groups, in particular with 1-30 C atoms. In one preferred embodiment, all substituents R^{a}-R^{e} are absent or alkyl groups, in particular unsubstituted alkyl groups with 1-30 C atoms.

In more specific embodiments of the boron-doped perylene or terrylene derivatives having the above Formulae **II** or **IV,** the substituents X, Y, L, M are O or S, preferably O, and/or R^{a}-R^{f} independently are absent, i.e. one or more of m, n, p, q, s and t = 0, or alkyl groups, in particular with 1-30 C atoms. In one preferred embodiment, all substituents R^{a}-R^{f} are absent or alkyl groups, in particular unsubstituted alkyl groups with 1-30 or 1-20 C atoms.

According to a preferred embodiment of the boron-doped perylene or terrylene derivatives having the above Formulae **V** or **VI,** the (hetero)arene system Ar represents benzene.

According to further preferred embodiments of the boron-doped perylene or terrylene derivatives having the above Formulae **V** or **VI,** the substituents R^{a}-R^{f} independently are absent or alkyl groups, in particular with 1-30 C atoms, preferably 1-20 C atoms. In one preferred embodiment, all substituents R^{a}-R^{f} are absent or alkyl groups, in particular unsubstituted alkyl groups with 1-30 or 1- 20 C atoms.

In other specific embodiments of the boron-doped perylene or terrylene derivatives having the above Formulae **I, III** or **V,** the substituents R^{a}, R^{b}, and R^{e} independently are selected from the group comprising unsubstituted (hetero)aryl or (hetero)aryl which is substituted by one or more groups G, unsubstituted alkyne, alkene, alkyl, or alkoxy residues, and alkyne, alkene, alkyl, or alkoxy residues which are substituted by E and/or interrupted by D, as well as halogen, cyano, or nitro groups;
D is -CO-; -COO-; -S-; -SO-; -SO₂-; -O-; -NR¹-; -POR³-; -CR⁴=CR⁵-; or -C≡C-;
E is -OR⁶; -OM (M = Li, Na, K); -SR⁶; -SM (M = Li, Na, K) -NR¹R²; -N⁺R¹R²R³; -COR⁷; -COOR⁸; -COOM (M = Li, Na, K); -CONR¹R²; -CN; substituted phenyl; or halogen;
G is E, C₁-C₂₀alkyl, C₁-C₂₀ alkyl which is interrupted by D, C₁-C₂₀ perfluoroalkyl, C₁-C₂₀ alkoxy, or C₁-C₂₀alkoxy which is substituted by E and/or interrupted by D;
R¹-R⁸ independently are H, C₁-C₂₀ alkyl, C₁-C₂₀ alkyl which is interrupted by -O-.

More specifically, in the boron-doped perylene or terrylene derivatives having the above Formulae **I, III** or **V,** one or more of the substituents R^{a}, R^{b}, and R^{e} independently are selected from the group comprising (hetero)aryl, in particular benzene, which is substituted by one or more groups G, with G selected from the group comprising poly(alkylene) oxides, in particular a poly(ethylene oxide) such as tetra(ethylene oxide), unsubstituted alkyne, in particular ethynyl, unsubstituted alkyl or alkoxy, in particular with 1-20 C atoms, alkyl or alkoxy, in particular with 1-20 C atoms, which is interrupted by -O-, in particular a poly(ethylene oxide), or substituted by -O⁻, -COO⁻, or -N⁺R¹R²R³, and halogen.

In other specific embodiments of the boron-doped perylene or terrylene derivatives having the above Formulae, **II, IV** or **VI**, the substituents R^{a}, R^{b}, R^{e} and R^{f} independently are selected from the group comprising unsubstituted (hetero)aryl or (hetero)aryl which is substituted by one or more groups G, unsubstituted alkyne, alkene, alkyl, or alkoxy residues, and alkyne, alkene, alkyl, or alkoxy residues which are substituted by E and/or interrupted by D, as well as halogen, cyano, or nitro groups;
D is -CO-; -COO-; -S-; -SO-; -SO₂-; -O-; -NR¹-; -POR³-; -CR⁴=CR⁵-; or -C≡C-;
E is -OR⁶; -OM (M = Li, Na, K); -SR⁶; -SM (M = Li, Na, K) -NR¹R²; -N⁺R¹R²R³; -COR⁷; -COOR⁸; -COOM (M = Li, Na, K); -CONR¹R²; -CN; substituted phenyl; or halogen;
G is E, C₁-C₂₀ alkyl, C₁-C₂₀ alkyl which is interrupted by D, C₁-C₂₀ perfluoroalkyl, C₁-C₂₀ alkoxy, or C₁-C₂₀ alkoxy which is substituted by E and/or interrupted by D;
R¹-R⁸ independently are H, C₁-C₂₀ alkyl, C₁-C₂₀ alkyl which is interrupted by -O-.

More specifically, in the boron-doped perylene or terrylene derivatives having the above Formulae **II, IV** or **VI,** one or more of the substituents R^{a}, R^{b}, R^{e} and R^{f} independently are selected from the group comprising (hetero)aryl, in particular benzene, which is substituted by one or more groups G, with G selected from the group comprising poly(alkyene) oxides, in particular a poly(ethylene oxide), such as tetra(ethylene oxide), unsubstituted alkyne, in particular ethynyl, unsubstituted alkyl or alkoxy, in particular with 1-20 C atoms, alkyl or alkoxy, in particular with 1-20 C atoms, which is interrupted by -O-, in particular a poly(ethylene oxide), or substituted by -O⁻,-COO⁻, or-N⁺R¹R²R³, and halogen.

In one specific embodiment of the invention, the boron-doped perylene or terrylene derivatives are OBO-doped perylene or terrylene derivatives selected from the group of compounds having one of the following structural formulae 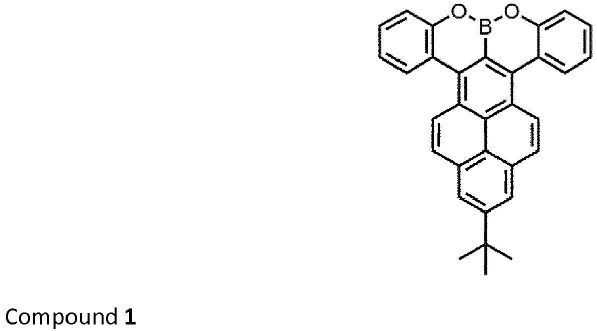 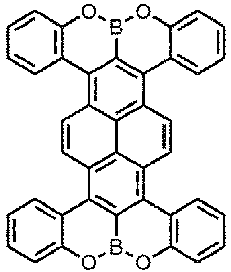 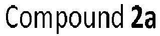 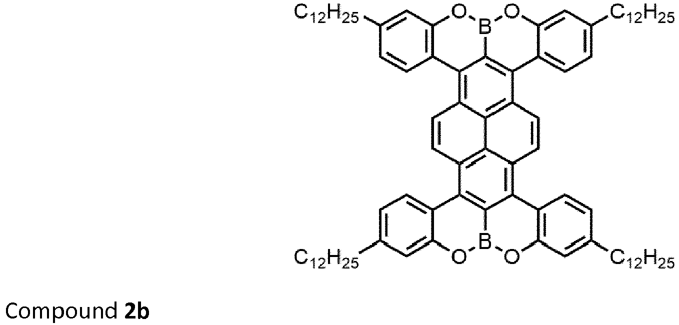 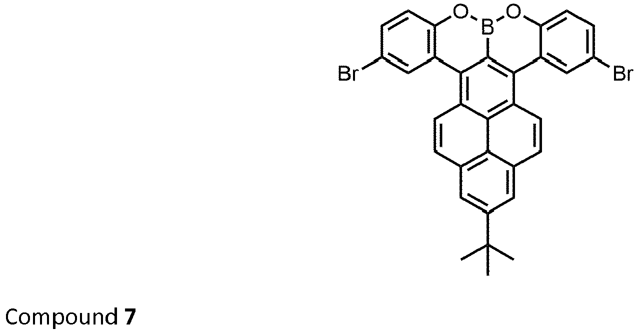 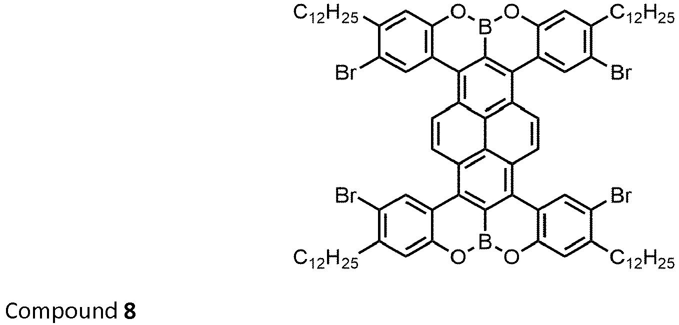 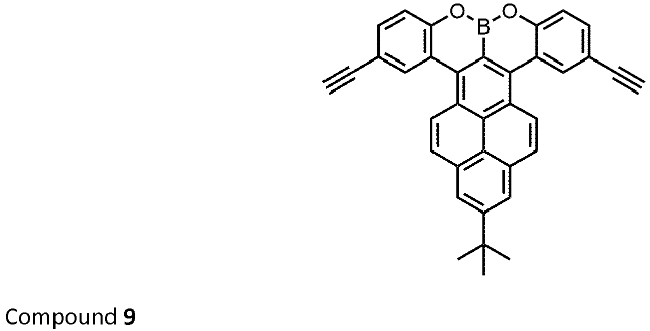 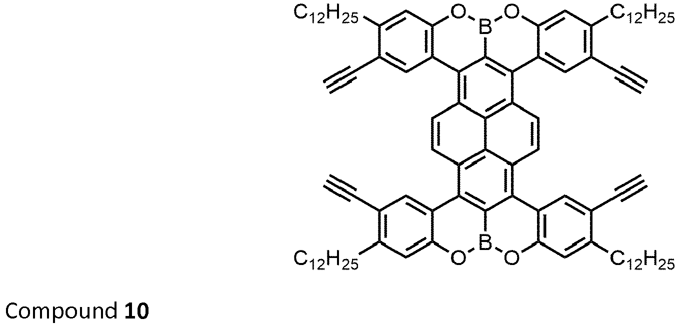 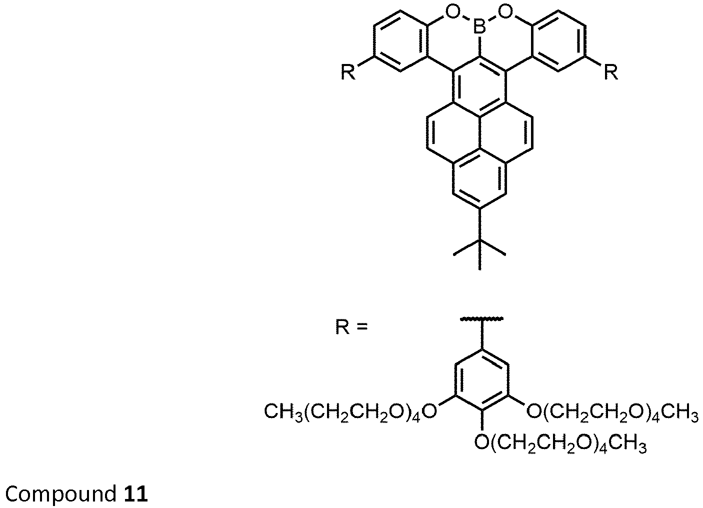 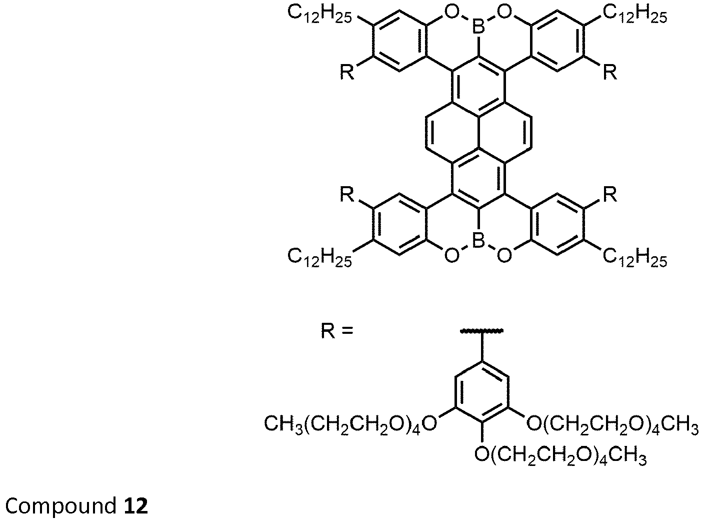 It should be understood that the bond types and locations in the chemical structures provided herein may adapt depending on the substituents in the compound, even if not specifically recited. For instance, - Z- where Z can be CR₍₂₎ or N(R) can be understood as -CR=, -CHR-, -CR₂-, -N=, -NH- or -NR-. Thus, even if not specifically illustrated, the chemical compounds described herein include any hydrogen atoms, lone pair of electrons and charges necessary for completing a chemical structure according to valence rules. This may include charges appearing in drawn mesomeric forms (e.g., -CR⁺- instead of -CR=, -N⁻-instead of-N= etc.) or tautomeric forms of the same chemical entity.

Generally, the term "substituted" as used herein is understood to include all permissible substituents of organic compounds, provided a) that such substitution is in accordance with permitted valence of the substituted atom and the substituent and b) that the substitution results in a compound sufficiently stable to perform under the conditions practical for the disclosed method, that is that a compound does not spontaneously undergo transformation such as by rearrangement, fragmentation, elimination, hydrolysis etc. long enough to practically perform as disclosed herein. In a broad aspect, the permissible substituents include acyclic and cyclic, branched and unbranched, carbocyclic and heterocyclic, aromatic and nonaromatic, neutral, positively and negatively charged substituents of organic compounds and combinations thereof. Unless stated otherwise, all chemical groups described herein include both unsubstituted and substituted varieties.

The term "substituted" as used herein, refers to the presence of one or more substituents. The substituents are not especially limited and in particular may be selected from the group comprising, but not limited to, optionally substituted (hetero)aryl, optionally substituted alkyl, cycloalkyl, alkoxy, alkenyl, cycloalkenyl, alkynyl, cycloalkynyl, ester, ether, amine, nitro, halide, cyano, hydroxy, ketone, azide, silyl, sulfonyl, sulfide or thiol.

More specifically, the substituents may be selected from the group comprising optionally substituted (hetero)aryl, optionally substituted alkyl, including straight or branched alkyl including lower alkyl, typically C₁-C₃₀ alkyl, in particular C₁-C₁₂ alkyl, or halogen, such as F, Cl, Br, I.

The terms "alkyl" or "cycloalkyl", as used herein, generally comprise any unsubstituted or substituted (cyclo)alkyl groups, typically with 1-30 or more C atoms, more specifically 1-20 C atoms or 1-15 C atoms, in particular also a lower (cyclo)alkyl group. If not defined more specifically, the term "lower alkyl group" refers to C₁-C₁₂ alkyl groups, more preferred C₁-C₆ or C₁-C₄ alkyl groups. Some non-limiting examples thereof are methyl, ethyl, propyl, isopropyl, n-butyl, isobutyl, *sec*-butyl, pentyl, isopentyl, 2-methylbutyl, 2,2-dimethylpropyl, hexyl, isohexyl, 2-methyl-pentyl, 3-methylpentyl, 2,2-dimethylbutyl etc.

The term "Ar" or "aryl", as used herein, refers to an unsubstituted or substituted mono-, bi-, tri- or tetracycliccarbocyclic ring system having one, two, three or four aromatic rings including but not limited to phenyl, biphenyl, naphthyl, anthryl, azulyl, tetrahydronaphthyl, indanyl and indenyl.

The terms "heteroaryl" or "heterocycle", as used herein, generally refer to an unsubstituted or substituted cyclic aromatic radical (residue), typically having from 5 to 10 ring atoms of which at least one ring atom is selected from S, O, P and N; the radical being joined to the rest of the molecule via any of the ring atoms. Representative, but not limiting examples are furyl, thienyl, pyridinyl, pyrazinyl, pyrimidinyl, pyrrolyl, imidazolyl, thiazolyl, benzothiazolyl, oxazolyl, benzoxaxolyl, isooxazolyl, thiadiazolyl, oxadiazolyl, quinolinyl and isoquinolinyl.

The aryl or heteroaryl group can be substituted or unsubstituted. The aryl group can be substituted with one or more groups including, but not limited to, optionally substituted alkyl, cycloalkyl, alkoxy, alkenyl, cycloalkenyl, alkynyl, cycloalkynyl, ester, ether, nitro, halide, cyano, hydroxy, ketone, amino, azide, silyl, sulfonyl, sulfide or thiol, in the most broad sense applicable.

If not defined more specifically, the term "lower alkyl group" refers to C₁-C₁₂ alkyl groups, more preferred C₁-C₆ or C₁-C₄ alkyl groups. Some non-limiting examples thereof are methyl, ethyl, propyl, isopropyl, n-butyl, isobutyl, *sec*-butyl, pentyl, isopentyl, 2-methylbutyl, 2,2-dimethylpropyl, hexyl, isohexyl, 2-methyl-pentyl, 3-methylpentyl, 2,2-dimethylbutyl etc.

Alkyl groups may be further substituted with or interrupted by functional groups. These groups may be, e.g., selected from alkoxy, alkenyl, cycloalkenyl, alkynyl, cycloalkynyl, ester, ether, halide, cyano, hydroxy, ketone, amino, azide, silyl, sulfonyl, sulfide or thiol.

In particular, the substituted alkyl groups may be alkyl groups having fluoro-, chloro- or bromo substituents instead of hydrogen atoms, or alkoxy groups such as methoxy, ethoxy, tetraethylene glycol, etc

The term "alkenyl" as used herein is a hydrocarbon group of from 2 to 20 carbon atoms with a structural formula containing at least one carbon-carbon double bond. The term is inclusive of linear and cycle-containing (i.e., cycloalkenyl) groups. The alkenyl group can be substituted with one or more groups including, but not limited to, optionally substituted alkyl, cycloalkyl, alkoxy, alkenyl, cycloalkenyl, alkynyl, cycloalkynyl, ester, ether, halide, cyano, hydroxy, ketone, azide, silyl, sulfonyl, sulfide or thiol, in the broadest sense applicable.

The term "alkynyl" as used herein is a hydrocarbon group of from 2 to 20 carbon atoms with a structural formula containing at least one carbon-carbon triple bond. The term is inclusive of linear and cycle-containing (i.e., cycloalkynyl) groups. The alkynyl group can be substituted with one or more groups including, but not limited to, optionally substituted alkyl, cycloalkyl, alkoxy, alkenyl, cycloalkenyl, alkynyl, cycloalkynyl, ester, ether, halide, cyano, hydroxy, ketone, azide, silyl, sulfonyl, sulfide or thiol, in the broadest sense applicable.

The terms "amine" or "amino" as used herein are represented by a formula NA¹A²A³ or a substituent NA¹A², where A¹, A² and A³ can be, independently, hydrogen or optionally substituted alkyl, cycloalkyl, alkenyl, cycloalkenyl, alkynyl, cycloalkynyl, aryl or heteroaryl group as described herein. In specific embodiments amine refers to any of NH₂, NH(alkyl), NH(aryl), N(alkyl)₂, N(aryl)₂ or N(alkyl)(aryl).

A further aspect of the present invention relates to favorable methods for synthesizing the novel boron-doped perylene or terrylene derivatives described above.

For example, a method for preparing OBO-doped perylene or terrylene derivatives according to the present invention comprises at least the following steps:
a) providing a 1,3-dibromo-substituted or 1,3,6,8-tetrabromo-substituted pyrene compound and reacting the same with 2-methoxyaryl derivatives, preferably (2-methoxyaryl)boronic acid, in particular (2-methoxyphenyl)-boronic acid, or a derivative thereof which is further substituted at the aryl ring, in particular phenyl ring, in a transition-metal-catalyzed cross-coupling reaction, in particular palladium-catalyzed Suzuki coupling, to obtain the corresponding 1,3-bis(2-methoxyaryl)pyrene, in particular 1,3-bis(2-methoxyphenyl)pyrene compound or 1,3,6,8-tetrakis-(2-methoxyaryl)pyrene, in particular 1,3,6,8-tetrakis-(2-methoxyphenyl)-pyrene compound and
b) reacting the 1,3-bis(2-methoxyaryl)pyrene compound or 1,3,6,8-tetrakis-(2-methoxyaryl)pyrene compound with BX₃, in particular BBr₃, to obtain a 10,11-dioxa-10a-boratribenzo[*a,f,lm*)perylene or 11,12,23,24-tetraoxo-11a,23a-diboratetrabenzo-[*a,f,n,s*]terrylene compound.

Typically, the reaction of step a) is performed in a solvent selected from the group comprising tetrahydrofuran, toluene, dichloromethane, methanol, ethanol, isopropanol, acetone, acetonitrile, dimethylformamide, dimethylacetamide, dimethyl sulfoxide and water under conditions of stirring at 20^{∼}150 °C, preferably at 50^{∼}120 °C.

Typically, the reaction of step b) is performed in a solvent selected from the group comprising toluene, benzene, chlorobenzene, dichlorobenzene, trichlorobenzene under conditions of stirring at 100^{∼}230 °C, preferably at 140^{∼}180 °C.

In one specific embodiment of this method, in step a) of said method 1,3-dibromo-7-(*tert-butyl)pyrene* or 1,3,6,8-tetrabromopyrene or is provided and 2-(*tert*-*butyl*)-10,11-dioxa-10a-boratribenzo[*a,f,lm*)perylene (compound **1**) or 11,12,23,24-tetraoxo-11a,23a-diboratetrabenzo[*a,f,n,s*]terrylene (compound **2a**) or an alkyl-substituted derivative of the latter (compound **2b**) is obtained after step b).

The main steps in the synthesis of compounds **1**, and **2a**,**b** are depicted in the following **Scheme 1.**

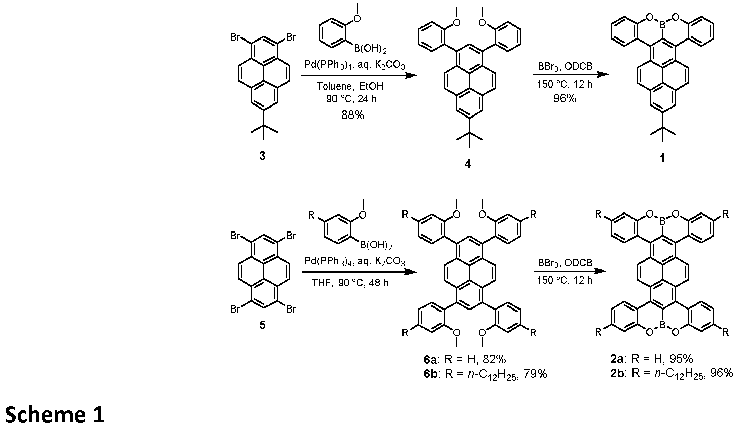

First, 7-(*tert*-butyl)-1,3-bis(2-methoxyphenyl)pyrene (**4**) was obtained through Suzuki coupling of 1,3-dibromo-7-(*tert*-butyl)pyrene (**3**) with (2-methoxyphenyl)boronic acid in 88 % yield. Then, demethylation and subsequent direct C-H borylation were performed by heating a solution of compound **4** and BBr₃ in o-dichlorobenzene (ODCB) at 150 °C, furnishing compound **1** in 96% yield. In a similar approach, four-fold Suzuki coupling of 1,3,6,8-tetrabomopyrene (**5**) with (2-methoxyphenyl)boronic acid provided 1,3,6,8-tetrakis(2-methoxyphenyl)pyrene (**6a**) in 82% yield, followed by tandem demethylation-borylation of **6a** affording compound **2a** in 95 % yield. Compound **2b** with dodecyl chains was synthesized in the same manner to improve the solubility of the target compound in non-polar media. The chemical structures of **1** and **2b** were verified by ¹H, ¹³C, and 2D NMR as well as high-resolution MALDI-TOF MS (see the Supporting Information). However, further characterization of **2a**, except high-resolution MALDI-TOF MS, was prevented by its poor solubility in non-polar media.

The present invention also relates to a method for preparing the boron-doped perylene or terrylene derivatives as described above comprising the following steps:
a) halogenation, in particular bromination, of the boron-doped perylene or terrylene derivative obtained by the method according to claims 11 or 12, and
b) functionalizing the halogenated, in particular brominated, compound through transition-metal catalyzed cross-coupling reactions, preferably Suzuki coupling, Stille coupling,
Sonogashira coupling, Kumada coupling, Negishi coupling, Heck reaction, to further expand the boron-doped perylene or terrylene derivatives.

The novel boron-doped perylene and terrylene derivatives of the present invention exhibit favorable optical characteristics such as strong fluorescence, high quantum yields and charge transport properties and thus, are suitable for various applications in the field of optics, electronic and optoelectronic devices etc.

Consequently, further aspects of the present invention relate to such uses, e.g. the use of the claimed compounds as an electroluminescent material, their use in an electronic or optoelectronic device or in a component therefore, in particular their use in organic light emitting diodes (OLEDs).

Another closely related aspect of the invention relates to OLEDs, organic integrated circuits (O-ICs), organic field effect transistors (OFETs), organic thin film transistors (OTFTs), organic solar cells (O-Scs), fluorescent sensors, thermoelectric devices, electrochromic devices, or organic laser diodes, comprising one or more of the boron-doped perylene or terrylene derivatives according to the present invention.

### Brief Description of the Figures

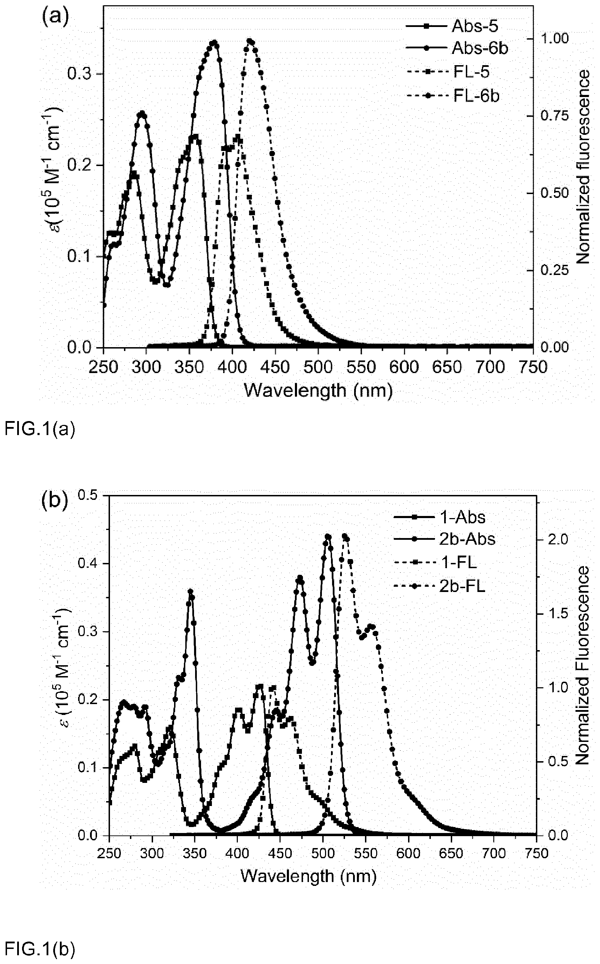

**Fig. 1** shows the UV-vis absorption and fluorescence spectra of compounds **4** and **6b** in comparison with those of compounds **1** and **2b,** respectively, in CHCl₃.
**Fig. 2** shows the UV-vis absorption and fluorescence spectra of (a) compound **1** and (b) compound **2b**, respectively, in a series of mixed solvents of CHCl₃ and CH₃OH.
**Fig. 3** shows fluorescence spectra of compound **1** and **2b** in polystyrene (PS) matrix with different concentrations from 0.25 wt% to the neat film.
**Fig. 4** shows the transfer (a,c) and output (b,d) characteristics of the OFETs based on (a,b) dip-coated compound **1** and (c,d) spin-coated compound **2b.**

The following examples are given to illustrate the present invention in more detail, without, however, limiting the same to the specific embodiments thereof.

### General Materials and Methods

All commercially available chemicals were used without further purification unless otherwise noted. Column chromatography was conducted with silica gel (grain size 0.063-0.200 mm or 0.04-0.063 mm) and thin layer chromatography (TLC) was performed on silica gel-coated aluminum sheets with F254 indicator. Nuclear magnetic resonance (NMR) spectra were recorded on Bruker Avance 300 or 500 MHz spectrometer. Chemical shifts were reported in ppm. Coupling constants (J values) were presented in Hertz (Hz). ¹H NMR chemical shifts were referenced to CD₂Cl₂ (5.32 ppm) or C₂D₂Cl₄ (6.00 ppm). ¹³C NMR chemical shifts were referenced to CD₂Cl₂ (53.84 ppm) or C₂D₂Cl₄ (73.78 ppm). Abbreviations: s = singlet, d = doublet, dd = double doublet, t = triplet, m = multiplet. High-resolution mass spectrometry (HRMS) was performed on a SYNAPT G2 Si high resolution time-of-flight (TOF) mass spectrometer (Waters Corp., Manchester, UK) by matrix-assisted laser desorption/ionization (MALDI). Melting points were measured with a Büchi B-545 apparatus. Absorption spectra were recorded on a Perkin-Elmer Lambda 900 spectrophotometer. Photoluminescence spectra were recorded on a J&MTIDAS spectrofluorometer. The quantum yield was measured with 9,10-diphenylanthracene (in toluene under air, *Φ*_{F}: 0.70) or fluorescein (in 0.1 N NaOH under air, *Φ*_{F}: 0.90) as a reference. Cyclic voltammetry (CV) was performed on a WaveDriver 20 Bipotentiostat/Galvanostat (Pine Instruments Company) and measurements were carried out in tetrahydrofuran (THF) containing 0.1 M *n*-Bu₄NPF₆ as supporting electrolyte (scan rate: 100 mV s⁻¹). A glassy carbon electrode was used as a working electrode, a platinum wire as a counter electrode and a silver wire as a reference electrode.

### EXAMPLE 1

### Synthesis of 2-(tert-butyl)-10,11-dioxa-10a-boratribenzo[a,f,lm]perylene

### A. Synthesis of 7-(tert-butyl)-1,3-bis(2-methoxyphenyl)pyrene (4)

To a Schlenk tube charged with 1,3-dibromo-7-*tert*-butylpyrene (**3**) (300 mg, 0.721 mmol), (2-methoxyphenyl)boronic acid (438 mg, 2.88mmol), potassium carbonate (797 mg, 5.77 mmol) and tetrakis(triphenylphosphine)palladium(0) (83 mg, 0.072 mmol) under argon was added toluene (25 mL, degassed) and a mixture of water/ethanol (7 mL : 7 mL, degassed). The reaction mixture was stirred at 90 °C for 12 h. After cooling to room temperature, the mixture was extracted with Et₂O and washed with water. Then the organic phase was dried over MgSO₄. After removal of the solvent under reduced pressure, the residue was purified by column chromatography over silica gel (eluent: hexane/CH₂Cl₂ = 2 :1) to give compound **4** as a white solid (300 mg, 88% yield). M.p.: 162.8 - 163.9 °C. ¹H NMR (500 MHz, C₂D₂Cl₄, 403 K, ppm) *δ* 8.22 (s, 2H), 8.01 (dd, *J* = 9.3, 1.4 Hz, 2H), 7.94 - 7.86 (m, 3H), 7.54 - 7.45 (m, 4H), 7.21 - 7.11 (m, 4H), 3.77 (d, *J* = 11.8 Hz, 6H), 1.61 (s, 9H); ¹³C NMR (125 MHz, C₂D₂Cl₄, 403 K, ppm) 6 157.79, 149.05, 133.67, 132.37, 131.14, 130.72, 130.02, 128.68, 128.47, 126.67, 125.75, 124.79, 123.24, 121.78, 121.74, 120.74, 112.66, 56.01, 31.67; HRMS (MALDI) m/z: Calcd for C₃₄H₃₀O₂: 470.2246; Found: 470.2238 [M]⁺.

### B. Synthesis of 2-(tert-butyl)-10,11-dioxa-10a-boratribenzo[a,f,lm]perylene (1)

To a solution of **4** (100 mg, 0.212 mmol) in anhydrous dichlorobenzene (10 mL) under argon was added BBr₃ (1.0 M in heptane, 0.32 mL, 0.32 mmol). Then the mixture was heated to 150 °C and stirred at this temperature for 12 h. After cooling to room temperature, the reaction mixture was quenched with methanol and concentrated under reduced pressure. Then the residue was purified by column chromatography over a short pad of silica gel with dichloromethane as the eluent to give compound **1** as a yellow solid (92 mg, 96% yield). M.p.: 295.6 - 296.5 °C. ¹H NMR (500 MHz, C₂D₂Cl₄, 403 K, ppm) *δ* 9.05 (d, *J* = 9.3 Hz, 2H), 8.74 (dd, *J* = 8.1, 1.6 Hz, 2H), 8.36 (s, 2H), 8.27 (d, *J* = 9.4 Hz, 2H), 7.66 (d, *J* = 8.2 Hz, 2H), 7.60 - 7.53 (m, 2H), 7.47 - 7.40 (m, 2H), 1.73 (s, 9H); ¹³C NMR (125 MHz, C₂D₂Cl₄, 403 K, ppm) *δ* 152.49, 150.75, 132.46, 131.80, 129.87, 129.49, 129.05, 127.96, 125.15, 125.06, 124.52, 123.73, 122.79, 122.71, 120.35; HRMS (MALDI) *m*/*z:* Calcd for C₃₂H₂₃BO₂: 450.1791; Found: 450.1787 [M]⁺.

### EXAMPLE 2

### Synthesis of 11,12,23,24-tetraoxa-11a,23a-diboratetrabenzo[a,f,n,s]terrylene

### A. Synthesis of 1,3,6,8-tetrakis(2-methoxyphenyl)pyrene (6a)

To a Schlenk tube charged with 1,3,6,8-tetrabromopyrene (**5**) (500 mg, 0.966 mmol), 2-methoxybenzeneboronic acid (1.18 g, 7.76 mmol) and tetrakis-(triphenylphosphine)palladium(0) (224 mg, 0.194 mmol) under argon was added THF (45 mL, degassed) and a solution of potassium carbonate in water (8 mL, 2 M). The resulting mixture was stirred at 90 °C for 48 h. After cooling to room temperature, the reaction mixture was filtered off and washed with water, methanol and CH₂Cl₂ consecutively. The residue was then dissolved in hot 1,1,2,2-tetrachloroethane and filtered through a PTFE membrane into a filter flask containing methanol. Precipitates were thus obtained and collected by filtration to give compound **6a** as a white solid (496 mg, 82% yield). M.p.: 337.5 - 338.9 °C. ¹H NMR (500 MHz, C₂D₂Cl₄, 403 K, ppm) *δ* 7.96 (s, 2H), 7.87 (s, 4H), 7.50 (dd, *J* = 18.1, 8.5 Hz, 8H), 7.20 - 7.14 (m, 8H), 3.76 (s, 12H); ¹³C NMR (125 MHz, C₂D₂Cl₄, 403 K, ppm) *δ* 157.79, 133.58, 132.40, 130.79, 130.30, 128.71, 128.63, 125.10, 120.67, 112.53, 55.99; HRMS (MALDI) *m*/*z:* Calcd for C₄₄H₃₄O₄: 626.2457; Found: 626.2480 [M]⁺.

### B. Synthesis of 11,12,23,24-tetraoxa-11a,23a-diboratetrabenzo[a,f,n,s]terrylene (2a)

To a solution of **6a** (100 mg, 0.160 mmol) in anhydrous dichlorobenzene (10 mL) under argon was added BBr₃ (1.0 M in heptane, 0.49 mL, 0.49 mmol). Then the mixture was heated to 150 °C and stirred at this temperature for 12 h. After cooling to room temperature, 20 mL of methanol was added. The precipitate was filtered and washed with methanol as well as 15 mL of CH₂Cl₂. The solid was dried under vacuum to give compound **2a** as a red solid (89 mg, 95% yield. M.p.: > 380 °C. The poor solubility of this compound prevents any NMR characterizations. HRMS (MALDI) *m*/*z:* Calcd for C₄₀H₂₀B₂O₄: 586.1548; Found: 586.1567 [M]⁺.

### EXAMPLE 3

### Synthesis of 2,9,14,21-tetradodecyl-11,12,23,24-tetraoxa-11a,23a-diboratetrabenzo[a,f,n,s]terrylene

### A. Synthesis of 1,3,6,8-tetrakis(4-dodecyl-2-methoxyphenyl)pyrene (6b)

To a Schlenk tube charged with 1,3,6,8-tetrabromopyrene (**5**) (200 mg, 0.386 mmol), (4-dodecyl-2-methoxyphenyl)boronic acid (618 mg, 1.93 mmol) and tetrakis(triphenylphosphine)palladium(0) (89 mg, 0.077 mmol) under argon was added THF (20 mL, degassed) and a solution of potassium carbonate in water (2 mL, 2 M). The reaction mixture was stirred at 90 °C for 48 h. After cooling to room temperature, the mixture was extracted with Et₂O and washed with water. Then the organic phase was dried over MgSO₄. After removal of the solvent under reduced pressure, the residue was purified by column chromatography over silica gel (eluent: hexane/ CH₂Cl₂ = 2 : 1) to afford compound **6b** as colorless oil (397 mg, 79% yield). ¹H NMR (500 MHz, C₂D₂Cl₄, 403 K, ppm) 6 7.93 (s, 2H), 7.87 (s, 4H), 7.39 (d, *J* = 7.5 Hz, 4H), 7.02 - 6.97 (m, 8H), 3.74 (s, 12H), 2.80 (t, *J* = 7.7 Hz, 8H), 1.84 (p, *J* = 7.3 Hz, 8H), 1.39 (s, 72H), 0.98 (t, *J* = 6.7 Hz, 12H); ¹³C NMR (125 MHz, C₂D₂Cl₄, 403 K, ppm) 6 157.64, 143.75, 133.60, 132.14, 130.52, 128.70, 128.11, 125.03, 120.68, 112.84, 55.06, 35.88, 31.57, 30.85, 29.32, 29.29, 22.25, 13.52; HRMS (MALDI) *m*/*z*: Calcd for C₉₂H₁₃₀O₄: 1298.9969; Found: 1298.9901 [M]⁺.

### B. Synthesis of 2,9,14,21-tetradodecyl-11,12,23,24-tetraoxa-11a,23a-diboratetra-benzo[a,f,n,s]terrylene (2b)

To a solution of **6b** (150 mg, 0.115 mmol) in anhydrous dichlorobenzene (12 mL) under argon was added BBr₃ (1.0 M in heptane, 0.35 mL, 0.35 mmol). Then the mixture was heated to 150 °C and stirred at this temperature for 12 h. After cooling to room temperature, the reaction mixture was quenched with methanol and concentrated under reduced pressure. Then the residue was purified by column chromatography over a short pad of silica gel with hot chloroform as the eluent to give compound **2b** as a red solid (140 mg, 96% yield). M.p.: 146.3 - 147.8 °C. ¹H NMR (500 MHz, C₂D₂Cl₄, 403 K, ppm) *δ* 9.00 (s, 4H), 8.72 (d, *J* = 8.1 Hz, 4H), 7.51 (s, 4H), 7.33 (d, *J* = 8.1 Hz, 4H), 2.89 (t, *J* = 7.6 Hz, 8H), 1.90 (p, *J* = 7.5 Hz, 8H), 1.40 (s, 72H), 0.98 (t, *J* = 6.7 Hz, 12H); ¹³C NMR (125 MHz, C₂D₂Cl₄, 403 K, ppm) *δ* 152.46, 144.96, 133.34, 130.04, 129.18, 124.77, 124.74, 123.00, 121.84, 119.82, 35.42, 31.58, 30.46, 29.34, 29.30, 29.27, 29.24, 29.21, 29.16, 29.11, 28.95, 22.25; HRMS (MALDI) *m*/*z:* Calcd for C₈₈H₁₁₆B₂O₄: 1258.9060; Found: 1258.9042 [M]⁺.

### EXAMPLE 4

### Characterization of compounds 1 and 2b

### Photophysical properties

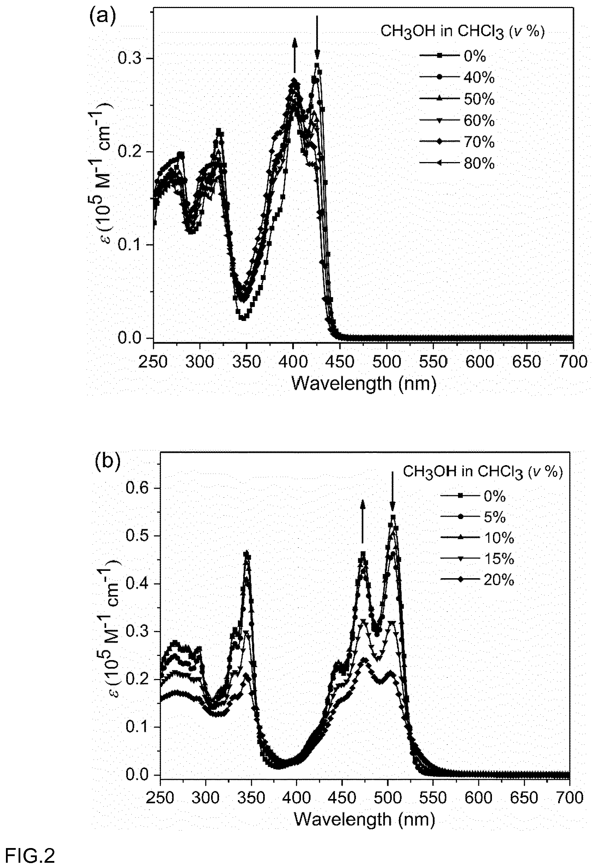

The photophysical properties of compounds **1** and **2b** were investigated in CHCl₃ solutions to elucidate the consequence of π-annulation at the non-K-regions (Figure 2). The absorption/emission maxima of **1** (426/442 nm) and **2b** (506/525 nm) are significantly red-shifted relative to their respective precursors **4** (357/406 nm) and **6b** (378/423 nm), indicating that the cyclization effectively extends the π-conjugation. Additionally, compared with the one-side π-extended pyrene derivative **1**, the double-side π-extended compound **2b** exhibits a lower optical gap (2.35 eV for **2b**; 2.81 eV for **1**) and a higher maximum absorption coefficient. These observations clearly reveal that the π-annulation at the non-K-region of pyrene has a significant impact on the optical and electronic properties. The fluorescence quantum yields of compounds **1** and **2b** were measured with 9,10-diphenylanthracene and fluorescein as the respective references. Notably, compound **1** displays a blue fluorescence (*λ*ₘₐₓ: 442 nm) with a quantum yield as high as 70%, whereas it reaches 84% for **2b** with a green fluorescence (*λ*ₘₐₓ: 525 nm). The Stokes shifts of **1** and **2b** are 16 and 19 nm, respectively, presumably due to the relatively rigid molecular skeletons. Both compounds are very stable under ambient conditions, having no changes in their photophysical features and in their NMR spectra after several months.

### Electrochemical properties

The electrochemical properties of compounds **1** and **2b** were studied by cyclic voltammetry. With ferrocene as an external standard, the HOMO and LUMO energy levels of **1** were estimated to be -5.24 and -2.72 eV, respectively. Only the oxidative wave was observed for **2b**, whose HOMO level was determined as -5.03 eV. The LUMO level was thus calculated by the electrochemical HOMO level and the optical energy gap as -2.68 eV.

### ¹H NMR analysis

Temperature-dependent ¹H NMR analysis of compounds **1** and **2b** in C₂D₂Cl₄ (data not shown) revealed that the aromatic protons from both molecules exhibited an upfield shift as the temperature decreased from 403 K to 298 K, indicating a strong aggregation tendency in a face-to-face manner.

### UV-vis absorption spectra

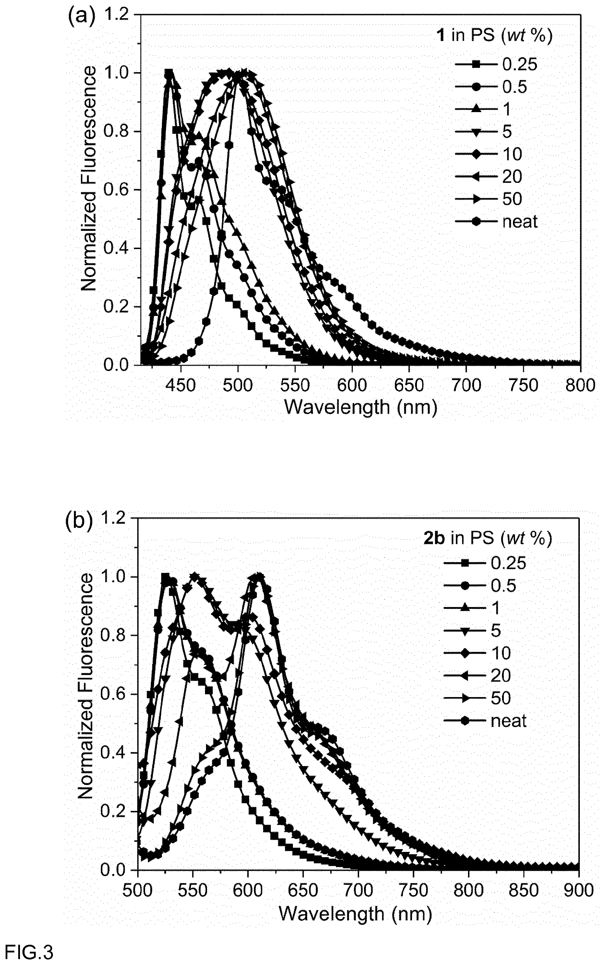

To further investigate the self-assembly behavior of compounds **1** and **2b**, solvent-dependent UV-vis absorption spectra in a mixed solvent of CHCl₃/CH₃OH were acquired with a fixed concentration at room temperature. CHCl₃ is a good solvent for the solvation of **1** and **2b**, which does not hold true for CH₃OH. As illustrated in Figure 2, compound **1** in pure CHCl₃ displays an absorption spectrum with well-resolved vibronic structures (Figure 2a), corresponding to a monomer-dominated absorption. Upon increasing the CH₃OH content in the mixed solvent from 30% to 80%, the aggregation starts to appear as evidenced by the spectral changes. The prominent feature is a reduction of the monomer-dominated absorption maximum at 426 nm and a relative increase of the aggregate-induced peak which is blue-shifted to 402 nm. The blue-shift of the absorption maximum is consistent with the characteristic of an H-aggregation behavior. A similar trend in the solvent-dependent absorption spectra was observed for compound **2b** (Figure 2b), displaying a decreased peak intensity at 506 nm (monomer-dominated) and relatively increased peak intensity at a blue-shifted wavelength 473 nm (aggregate-dominated) upon increasing the amount of CH₃OH in the binary solvent. These features also suggest H-type aggregation of compound **2b** in the presence of a poor solvent. It is however noteworthy that obvious spectral changes are already observed at a lower CH₃OH content (from 5% to 20%) for **2b** than that for 1 (starting to see the changes from 40%), suggesting a stronger π-π interaction of **2b** due to the larger π-skeleton. The absorption spectra of compounds **1** and **2b** in drop-casted thin films were also recorded (data not shown). Compared with their absorption spectra in CHCl₃ solution, both compounds in the solid state exhibit blue-shifted absorption maxima, in agreement with the aggregation behavior in solution. The fluorescence spectra of compounds **1** and **2b** in polystyrene (PS) matrix and in neat film reveal red shifts of the emission maxima, due to the aggregation in the solid state (Figure 3). The strong intermolecular interaction observed for both compounds is believed to be interesting for self-assembly studies and favorable for charge transport.

### Charge transport properties

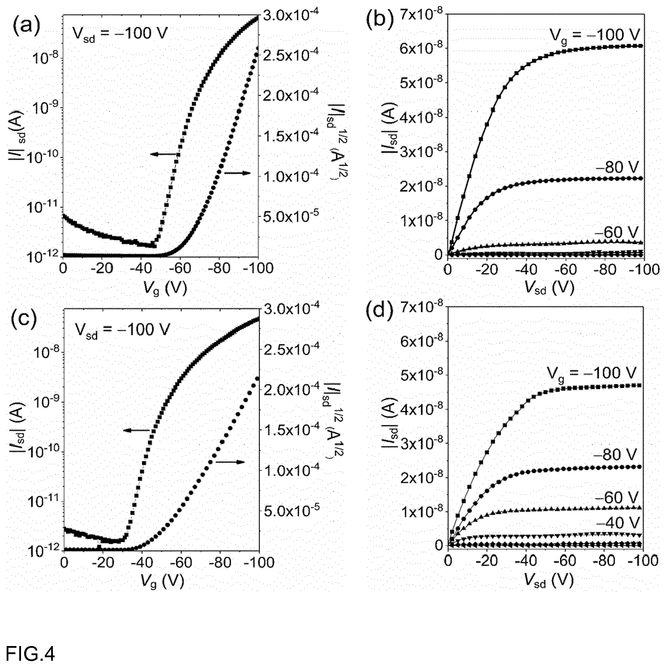

The charge transport properties of compounds **1** and **2b** were investigated based on bottom-gate top-contact OFET devices. Heavily n-doped silicon wafers were used as the gate electrode and thermally grown SiO₂ (300 nm thick) was employed as the dielectric layer. Organic thin films were fabricated on the Si/SiO₂ substrate and gold was then deposited as the source and drain electrodes to furnish the OFET devices. To deposit the organic films, the spin-coating method was first performed for both **1** and **2b**, but only compound **2b** exhibited a homogenous film. The spin-coated film of compound **1** was discontinuous, probably caused by the dewetting effect due to the lack of flexible alkyl chains. Accordingly, dip-coating was performed for compound **1** by using a blend of compound **1** and poly(methyl methacrylate) (PMMA) in CHCl₃ with a weight ratio of 1:1 to deposit the thin film (data not shown). In contrast, discontinuous fibres of compound **2b** were obtained by the same dip-coating process due to its low concentration caused by the limited solubility. Therefore, OFETs based on the dip-coated film of compound **1** exhibited a hole mobility around 1.5 × 10⁻³ cm² V⁻¹ S⁻¹ with an on/off ratio of 5 × 10⁴ (Figure 4a,b), and the devices based on the spin-coated film of compound **2b** gave a hole mobility around 2 × 10⁻⁴ cm² V⁻¹ s⁻¹, with an on/off ratio of 6 × 10⁴ (Figure 4c,d). The device performance of these two molecules cannot be directly compared because of the different fabrication methods, but the preliminary results have demonstrated the charge transport capability for both compounds. The mobility could be improved by further optimizing the device fabrication parameters, for example, the film deposition conditions and the surface modification of the substrates, etc.

### Device fabrication and measurement

The electrical properties were measured by fabricating bottom-gate top-contact OFET devices. Heavily n-doped silicon wafers were used as the gate electrode and thermally grown 300-nm-thick SiO₂ (capacitance: 11.0 nF cm⁻²) was adopted as the dielectric layer. The Si/SiO₂ substrates were sonicated in acetone and 2-propanol, respectively, and then treated by an oxygen plasma. The semiconductor layer of compound **2b** was spin coated from a CHCl₃ solution (1 mg/mL); that of compound **1** was dip-coated by using a blend of compound **1** and PMMA in CHCl₃ with a weight ratio of 1 : 1. Then source and drain gold electrodes were deposited on top of the organic thin films. The characteristics of the OFETs were measured at room temperature in a glove box by using a Keithley 4200 semiconductor parameter analyzer. The charge carrier mobility was calculated in the saturated region by the equation *l*_{sd} = (*W*/2*L*)*Cᵢµ*(*V_{g}* - *Vₜₕ*)², where *l*_{sd} is the source/drain current in the saturated regime; *W* is the channel width (500 µm) and *L* is the channel length (25 µm); *V*_{g} and *V*ₜₕ are the gate and threshold voltage, respectively; *C*ᵢ is the capacitance per unit area of the gate dielectric layer. Current on/off ratio was calculated from the *l*_{sd} at *V*_{g} *=* 0 V (*l*_{off}) and *V*_{g} = -100 V (*l*ₒₙ).

### Summary

It has been demonstrated that direct C-H borylation by the approach described herein readily occurs at the 2- and 2,7-positions of pyrene and furnishes the first oxaborin-annelated pyrene derivatives in high yields. The extended π-conjugation at the non-K-region of pyrene has shown a significant impact on the optical and electronic properties. It is remarkable that strong blue fluorescence (*λ*ₘₐₓ: 442 nm; *Φ*_{F}: 70%) has been observed for compound **1**, which would be desirable for OLEDs as stable blue emitters. Compound **2b**, on the other hand, resembles the famous perylene diimide (PDI) dyes in many ways, e.g. a similar absorption feature, bright green fluorescence (*λ*ₘₐₓ: 525 nm; *Φ*_{F}: 84%), and a strong self-assembly tendency in solution. It could be an interesting new chromophore for optical and supramolecular studies. Furthermore, charge transport properties of **1** and **2b** have been demonstrated by OFET devices. This invention has revealed a new way of π-extension based on pyrene derivatives and provided a novel kind of materials which are promising for photonic and optoelectronic applications.

## Claims

1. A boron-doped perylene or terrylene derivative having one of the following general formulae 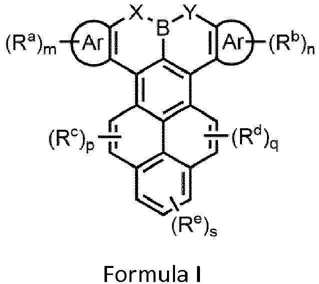
wherein X and Y independently are O, S, NH or NRx with Rx being any alkyl or (hetero)aryl group which may have substituent(s);
R^{a}, R^{b}, and R^{e} independently are selected from the group comprising unsubstituted or substituted (hetero)aryl, unsubstituted alkyne, alkene, alkyl, or alkoxy residues, and alkyne, alkene, alkyl, or alkoxy residues which are substituted or interrupted by other groups, as well as halogen, cyano, or nitro groups;
R^{c} and R^{d} independently are unsubstituted or substituted (hetero)aryl or alkyl groups, or halogen;
each Ar independently is an unsubstituted or substituted monocyclic or polycyclic (hetero)arene system;
m is an integer from 0 to 4; when m > 1, each R^{a} can be the same or different;
n is an integer from 0 to 4; when n > 1, each R^{b} can be the same or different;
p is an integer from 0 to 2; when p > 1, each R^{c} can be the same or different;
q is an integer from 0 to 2; when q > 1, each R^{d} can be the same or different;
s is an integer from 0 to 3; when e > 1, each R^{e} can be the same or different;
or 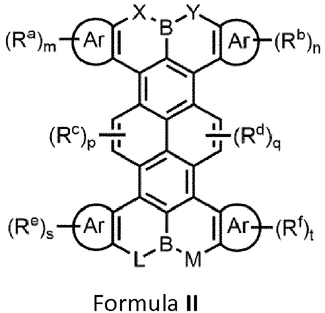
wherein X, Y, L and M independently are O, S, NH or NRx with Rx being any alkyl or (hetero)aryl group which may have substituent(s);
R^{a}, R^{b}, R^{e}, and R^{f} independently are selected from the group comprising unsubstituted or substituted (hetero)aryl, unsubstituted alkyne, alkene, alkyl, or alkoxy residues, and alkyne, alkene, alkyl, or alkoxy residues which are substituted or interrupted by other groups, as well as halogen, cyano, or nitro groups;
R^{c} and R^{d} independently are unsubstituted or substituted (hetero)aryl or alkyl groups, or halogen;
each Ar independently is an unsubstituted or substituted monocyclic or polycyclic (hetero)arene system;
m is an integer from 0 to 4; when m > 1, each R^{a} can be the same or different;
n is an integer from 0 to 4; when n > 1, each R^{b} can be the same or different;
p is an integer from 0 to 2; when p > 1, each R^{c} can be the same or different;
q is an integer from 0 to 2; when m > 1, each R^{d} can be the same or different;
s is an integer from 0 to 4; when s > 1, each R^{e} can be the same or different.
t is an integer from 0 to 4; when t > 1, each R^{f} can be the same or different;

2. The boron-doped perylene or terrylene derivative according to claim 1, wherein Ar is selected from the group comprising 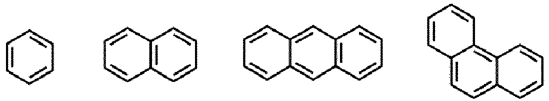 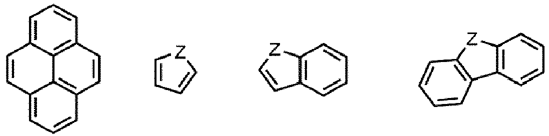
wherein Z is C or a heteroatom, in particular selected from the group comprising O, S, N and P;
each Ar is independently fused on the boron-doped perylene or terrylene core sharing one carbon-carbon bond at any peripheral positions;
the substituents R^{a}, R^{b} in Formula **I** and R^{a}, R^{b}, R^{e}, R^{f} in formula **II** are independently attached on the Ar group at any possible positions.

3. The boron-doped perylene or terrylene derivative according to claim 1 or 2, having one of the following general formulae 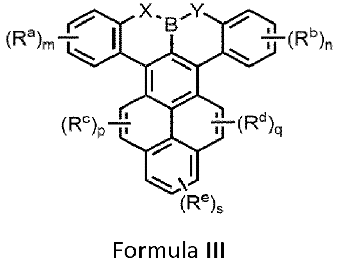 wherein X, Y, R^{a}-R^{e} and m, n, p, q and s are defined as in claim 1, or 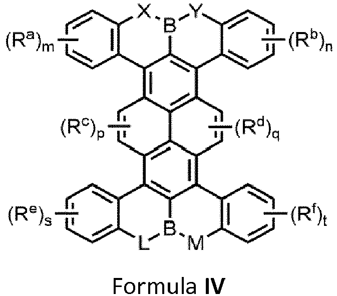 wherein X, Y, L, M, R^{a}-R^{f} and m, n, p, q, s and t are defined as in claim 1.

4. The boron-doped perylene or terrylene derivative according to claim 1 or 2, having one of the following general formulae 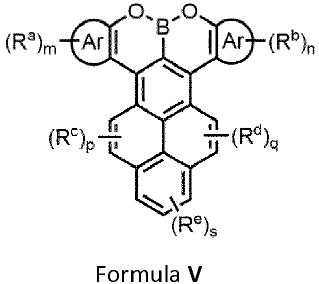 wherein Ar, R^{a}-R^{e} and m, n, p, q, s are defined as in claim 1 or 2, or 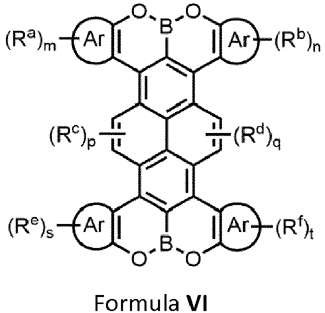 wherein Ar, R^{a}-R^{f} and m, n, p, q, s and t are defined as in claim 1 or 2.

5. The boron-doped perylene or terrylene derivative according to claim 4, wherein in Formula **V** or **VI** Ar represents benzene.

6. The boron-doped perylene or terrylene derivative according to claim 4 or 5, wherein R^{a}-R^{f} independently are absent or alkyl groups, in particular linear or branched alkyl chains with 1-30 C atoms.

7. The boron-doped perylene or terrylene derivative according to any one of claims 1-3, wherein in Formula **I** or **III**
X and Y = O or S, preferably O, and/or R^{a}-R^{e} independently are absent, i.e. one or more of m, n, p, q and s = 0, or alkyl groups, in particular linear or branched alkyl chains with 1-30 C atoms.
or in Formula **II** or **IV**
X, Y, L, M = O or S, preferably O, and/or R^{a}-R^{f} independently are absent, i.e. one or more of m, n, p, q, s and t = 0, or alkyl groups, in particular linear or branched alkyl chains with 1-30 C atoms.

8. The boron-doped perylene or terrylene derivative according to any one of claims 1-5, wherein in Formula **I, III** or **V**
R^{a}, R^{b}, and R^{e} independently are selected from the group comprising unsubstituted (hetero)aryl or (hetero)aryl which is substituted by one or more groups G, unsubstituted alkyne, alkene, alkyl, or alkoxy residues, and alkyne, alkene, alkyl, or alkoxy residues which are substituted by E and/or interrupted by D, and halogen;
D is -CO-; -COO-; -S-; -SO-; -SO₂-; -O-; -NR¹-; -POR³-; -CR⁴=CR⁵-; or -C≡C-;
E is -OR⁶; -OM (M = Li, Na, K); -SR⁶; -SM (M = Li, Na, K) -NR¹R²; -N⁺R¹R²R³; -COR⁷; -COOR⁸; -COOM (M = Li, Na, K); -CONR¹R²; -CN; substituted phenyl; or halogen;
G is E, C₁-C₂₀ alkyl, C₁-C₂₀ alkyl which is interrupted by D, C₁-C₂₀ perfluoroalkyl, C₁-C₂₀alkoxy, or C₁-C₂₀alkoxy which is substituted by E and/or interrupted by D;
R¹-R⁸ independently are H, C₁-C₂₀ alkyl, C₁-C₂₀ alkyl which is interrupted by -O-;
or in Formula **II, IV** or **VI**
R^{a}, R^{b}, R^{e} and R^{f} independently are selected from the group comprising unsubstituted (hetero)aryl or (hetero)aryl which is substituted by one or more groups G, unsubstituted alkyne, alkene, alkyl, or alkoxy residues, alkyne, alkene, alkyl, or alkoxy residues which are substituted by E and/or interrupted by D, and halogen;
D is -CO-; -COO-; -S-; -SO-; -SO₂-; -O-; -NR¹-; -POR³-; -CR⁴=CR⁵-; or -C≡C-;
E is -OR⁶; -OM (M = Li, Na, K); -SR⁶; -SM (M = Li, Na, K) -NR¹R²; -N⁺R¹R²R³; -COR⁷; -COOR⁸; -COOM (M = Li, Na, K); -CONR¹R²; -CN; substituted phenyl; or halogen;
G is E, C₁-C₂₀ alkyl, C₁-C₂₀ alkyl which is interrupted by D, C₁-C₂₀ perfluoroalkyl, C₁-C₂₀ alkoxy, or C₁-C₂₀ alkoxy which is substituted by E and/or interrupted by D;
R¹-R⁸ independently are H, C₁-C₂₀ alkyl, C₁-C₂₀ alkyl which is interrupted by -O-.

9. The boron-doped perylene or terrylene derivative according to claim 8, wherein in Formula **I, III** or **V**
one or more of R^{a}, R^{b}, and R^{e} independently are selected from the group comprising (hetero)aryl, in particular benzene, which is substituted by one or more groups G, with G selected from the group comprising poly(alkylene) oxides, in particular a poly(ethylene oxide) such as tetra(ethylene oxide), unsubstituted alkyne, in particular ethynyl, unsubstituted alkyl or alkoxy, in particular with 1-20 C atoms, alkyl or alkoxy, in particular with 1-20 C atoms, which is interrupted by -O-, in particular a poly(ethylene oxide), or substituted by -O⁻, -COO⁻, or-N⁺R¹R²R³, and halogen;
or in Formula **II, IV** or **VI**
R^{a}, R^{b}, R^{e} and R^{f} independently are selected from the group comprising (hetero)aryl, in particular benzene, which is substituted by one or more groups G, with G selected from the group comprising poly(alkyene) oxides, in particular a poly(ethylene oxide), such as tetra(ethylene oxide), unsubstituted alkyne, in particular ethynyl, unsubstituted alkyl or alkoxy, in particular with 1-20 C atoms, alkyl or alkoxy, in particular with 1-20 C atoms, which is interrupted by -O-, in particular a poly(ethylene oxide), or substituted by -O⁻, -COO⁻, or-N⁺R¹R²R³, and halogen.

10. The boron-doped perylene or terrylene derivative according to any one of claims 1-9 which is selected from the group comprising compounds **1, 2a, 2b and 7-12,** having the following structural formulae

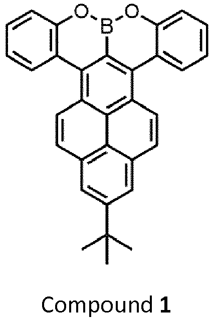

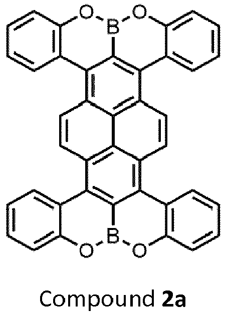

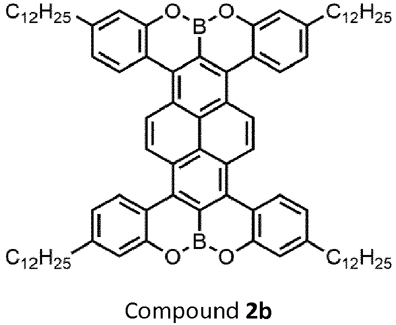

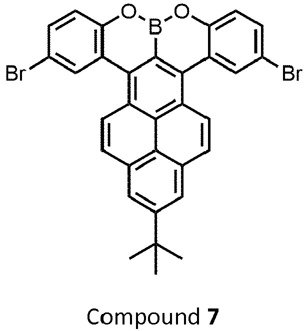

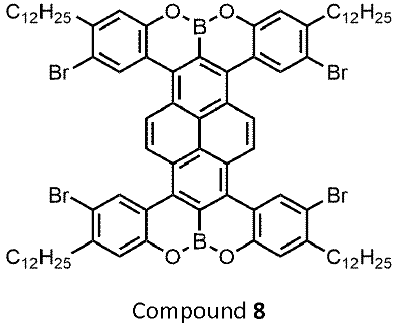

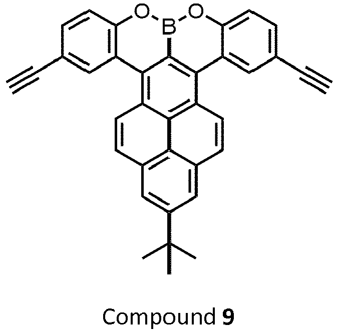

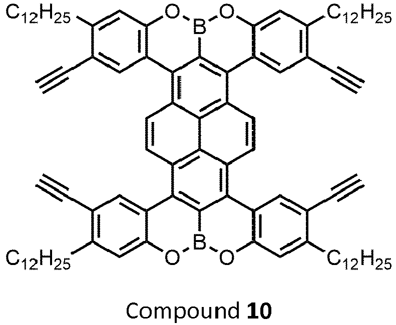

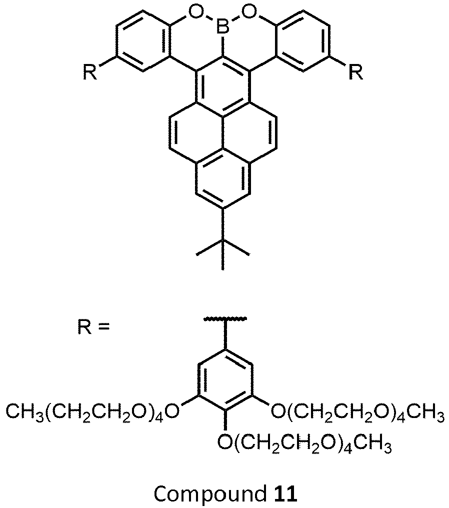

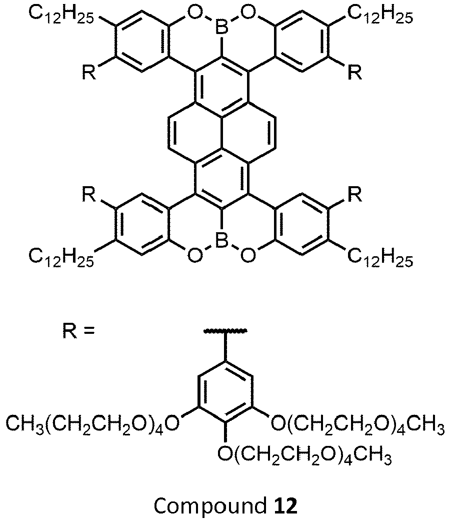

11. A method for preparing the boron-doped perylene or terrylene derivative according to any one of claims 4-7 comprising at least the following steps:
a) providing a 1,3-dibromo-substituted or 1,3,6,8-tetrabromo-substituted pyrene compound and reacting the same with 2-methoxyaryl derivatives, preferably (2-methoxyaryl)boronic acid, in particular (2-methoxyphenyl)-boronic acid, or a derivative thereof which is further substituted at the aryl ring, in particular phenyl ring, in a transition-metal-catalyzed cross-coupling reaction, in particular palladium-catalyzed Suzuki coupling, to obtain the corresponding 1,3-bis(2-methoxyaryl)pyrene, in particular 1,3-bis(2-methoxyphenyl)pyrene compound or 1,3,6,8-tetrakis-(2-methoxyaryl)pyrene, in particular 1,3,6,8-tetrakis-(2-methoxyphenyl)-pyrene compound and
b) reacting the 1,3-bis(2-methoxyaryl)pyrene compound or 1,3,6,8-tetrakis-(2-methoxyaryl)pyrene compound with BX₃, in particular BBr₃, to obtain a 10,11-dioxa-10a-boratribenzo[*a,f,lm*)perylene or 11,12,23,24-tetraoxo-11a,23a-diboratetrabenzo-[*a,f,n,s*]terrylene compound.

12. The method according to claim 11, wherein in step a) 1,3-dibromo-7-(*tert-butyl*)pyrene or 1,3,6,8-tetrabromopyrene is provided and 2-(*tert-butyl*)-10,11-dioxa-10a-boratribenzo-[*a,f,lm*)perylene or 11,12,23,24-tetraoxo-11a,23a-diboratetrabenzo-[*a,f,n,s*]terrylene is obtained after step b).

13. A method for preparing the boron-doped perylene or terrylene derivative according to any one of claims 4-7 comprising the following steps:
a) halogenation, in particular bromination, of the boron-doped perylene or terrylene derivative obtained by the method according to claims 11 or 12, and
b) functionalizing the halogenated, in particular brominated, compound through transition-metal catalyzed cross-coupling reactions, preferably Suzuki coupling, Stille coupling, Sonogashira coupling, Kumada coupling, Negishi coupling, Heck reaction, to further expand the boron-doped perylene or terrylene derivatives.

14. Use of the boron-doped perylene or terrylene derivative according to any one of claims 1-10 as electroluminescent material, in particular in organic light emitting diodes (OLEDs).

15. Use of the boron-doped perylene or terrylene derivative according to any one of claims 1-10 in an electronic or optoelectronic device or in a component therefore.

16. An electronic device or a component therefore, comprising the boron-doped perylene or terrylene derivative according to any one of claims 1-10.

17. OLEDs, organic integrated circuits (O-ICs), organic field effect transistors (OFETs), organic thin film transistors (OTFTs), organic solar cells (O-SCs), fluorescent sensors, thermoelectric devices, electrochromic devices, or organic laser diodes, comprising one or more of the boron-doped perylene or terrylene derivatives according to any one of claims 1-10.
